# EUROPEAN PATENT APPLICATION

(11) **EP 1 291 850 A1**
(43) Date of publication of application: **12.03.2003**
(21) Application number: 01919961.1
(22) Date of filing: 16.04.2001
(51) Int. Cl.: G10L 19/00, H03M 7/30

(54) **DECODER**

(30) Priority: 20.04.2000 JP 2000119801
(71) Applicant: Sanyo Electric Co., Ltd., Moriguchi-shi, Osaka-fu 570-8677 (JP)
(72) Inventor: YOSHIDA, Masanao, Osaka-shi, Osaka 547-0027 (JP); SAWAI, Masaharu, Neyagawa-shi, Osaka 572-0802 (JP); INOUE, Hajime, Soraku-gun, Kyoto 619-0225 (JP); MIYAZONO, Shinya, Amagasaki-shi, Hyogo 660-0822 (JP)
(74) Representative: Glawe. Delfs. Moll
(86) International application number: JP0103250
(87) International publication number: WO01082292

(57) **Abstract**

A plurality of decoding programs respectively corresponding to each of a plurality of compression formats is stored in a memory card 18 attached to a slot 16. A CPU 20 determines whether or not a decoding program corresponding to a compression format of music data to be reproduced exists in a RAM 22a, and transfers the decoding program from the memory card 18 to the RAM 22a according to the determination result. That is, when the decoding program corresponding to the compression format of the music data to be reproduced exists in the RAM 22a, the same decoding program is not transferred. The music data is decoded by a DSP 22 according to the decoding program stored in the RAM 22a.

## Description

### TECHNICAL FIELD

The present invention relates to a decoding apparatus applied to an audio player. More specifically, the present invention relates to a decoding apparatus for decoding an encoded signal encoded according to one of a plurality of formats.

### PRIOR ART

There are some audio players of such a kind expanding music data (encoded signal) compressed by a predetermined compression format according to an expansion program (decoding program) corresponding to the compression format. The expansion program is stored in an internal memory, and an expansion process of the music data is executed by a DSP (Digital Signal Processor). However, in a prior art, there is a limitation in a capacity of the internal memory storing the expansion program, and therefore, only the music data compressed by a format set in advance can be expanded. Herein, if decoding programs corresponding to the plurality of formats are prepared in advance in an external memory, and every time the music data to be reproduced is changed, a desired decoding program is loaded into the internal memory, it is possible to reproduce the music data compressed by a different format. However, if so, it is late to start the decoding process by the time required to load the decoding program.

### SUMMARY OF THE INVENTION

Therefore, it is a primary object of the present invention to provide a decoding apparatus capable of immediately starting a decoding process.

According to this embodiment, a decoding apparatus for decoding an encoded signal encoded according to any one of a plurality of encoding format, comprising: an attachment means for attaching an external memory storing a plurality of decoding programs respectively corresponding to the plurality of encoding formats; an internal memory for storing at least one of the plurality of decoding programs; a determination means for determining whether or not a specific decoding program corresponding to the encoding format of the encoded signal exists in the internal memory; a transfer means for transferring the specific decoding program from the external memory to the internal memory according to a determination result of the determination means; and a decoding means for decoding the encoded signal according to the decoding program stored in the internal memory.

The plurality of decoding programs respectively corresponding to the plurality of encoding formats are stored in the external memory. The attachment means attaches such the external memory. The determination means determines whether or not the specific decoding program corresponding to the encoding format of the encoded signal to be decoded exists in the internal memory, and the transfer means transfers the specific decoding program from the external memory to the internal memory according to the determination result of the determination means. That is, when the specific decoding program exists in the internal memory, a transfer process by the transfer means is never performed. The encoding signal is decoded by the decoding means according to the decode program stored in the internal memory. Accordingly, when a plurality of encoded signals according to the same encoding format are sequentially decoded, the specific decoding program is never transferred repeatedly, and therefore, it is possible to shorten a time to start the decoding process.

When a plurality of encoded signals corresponding to the same decoding format are stored in the external memory, an advantage of time shortening becomes conspicuous.

Furthermore, if a decoding program and an encoded signal which correspond to each other are stored in the same data file, it is easy to deal with data files.

It is noted that the encoded signal is, for example, a compressed music signal.

The above described objects and other objects, features, aspects and advantages of the present invention will become more apparent from the following detailed description of the present invention when taken in conjunction with the accompanying drawings.

### BRIEF DESCRIPTION OF THE DRAWINGS

Figure 1 is an illustrative view showing one embodiment of the present invention;
Figure 2 is a block diagram showing one part of the Figure 1 embodiment;
Figure 3 is an illustrative view showing one example of a recording state of a memory card;
Figure 4 is an illustrative view showing one example of a data structure of an audio file;
Figure 5 is an illustrative view showing one example of an additional information management table;
Figure 6 is an illustrative view showing another example of the additional information management table;
Figure 7 is an illustrative view showing one example of an audio file table;
Figure 8 is a flowchart showing one part of an operation in Figure 1 embodiment;
Figure 9 is a flowchart showing another part of the operation in Figure 1 embodiment; and
Figure 10 is a flowchart showing the other part of the operation in Figure 1 embodiment.

### BEST MODE FOR PRACTICING THE INVENTION

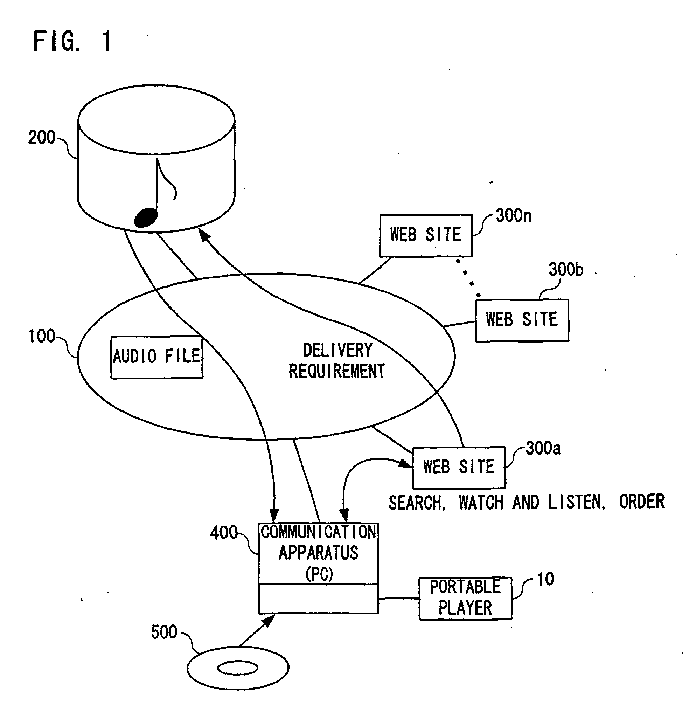

Referring to Figure 1, a decoding apparatus of this embodiment is applied to a portable audio player 10 decoding (expanding) compressed music data by a predetermined decode program. The portable audio player 10 is connected to a communication terminal 400 such as a personal computer. The communication terminal 400 is connected to the Internet 100, and an operator can gain access to a plurality of WEB sites 300a, 300b, ···300n via the Internet 100.

Among them, the WEB site 300a is a site to perform a delivery of the music data. Hereinafter, the music data is called "music" and " tune". When the operator gains access to the WEB site 300a from the communication terminal 400 so as to place an order for desired music (tune), the WEB site 300a requires delivery of the accepted tune to a database server 200 via the Internet 100. The database server 200 transmits a data file (audio file) including music data of the required music (tune) to the communication server 400 of an ordering source via the Internet 100. The transmitted audio file is stored in a hard disk of the communication terminal 400.

It is noted that the audio file is formed every one tune of the music data, and when the operator places an order for a music album including a plurality of tunes, a plurality of audio files are downloaded.

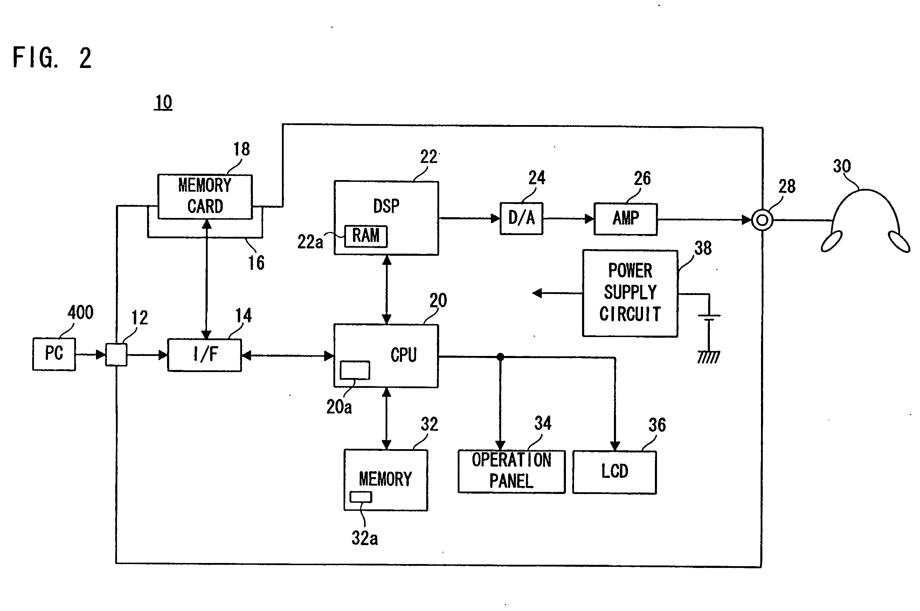

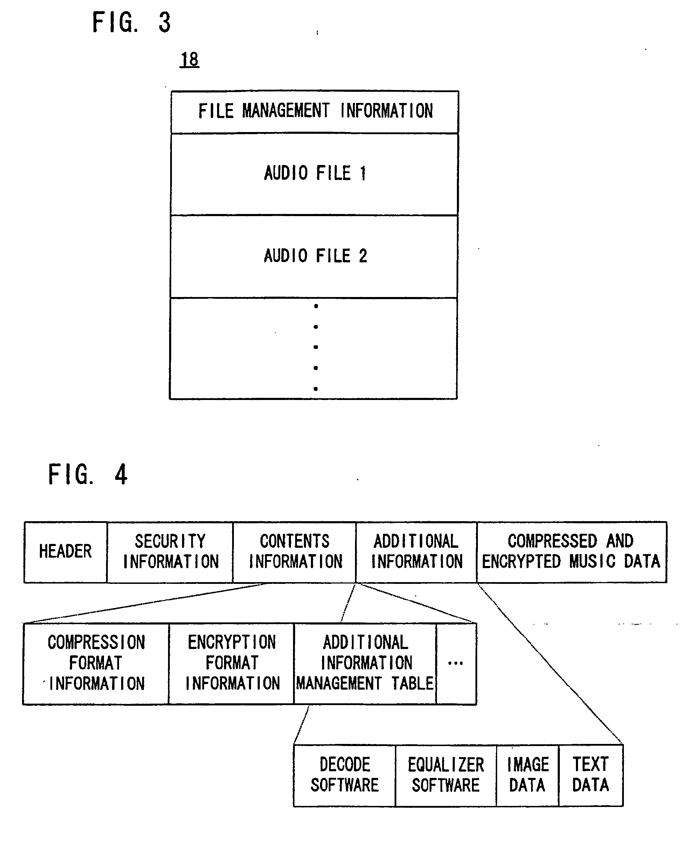

Referring to Figure 2, the audio files downloaded to the communication terminal 400 is input to the portable audio player 10 through an input terminal 12. The input audio files are recorded onto a memory card 18 via an interface 14. The audio files are recorded onto the memory card 18 as shown in Figure 3, and each of audio files are managed by file management information. It is noted that the memory card 18 is a detachable recording medium and is electrically connected to the interface 14 by being attached to a slot 16.

The audio file recorded onto the memory card 18 has a data configuration as shown in Figure 4. The memory card 18 is stored with security information, contents information and additional information in this order after a header, and stored with one tune of music data subjected to a compression process and an encryption process by a predetermined format successive to the additional information.

Encryption key information to prevent unauthorized copying of the audio file is included as the security information. With this encryption key information, it is possible to encrypt a code.

Furthermore, the contents information includes compression format information indicative of what format the music data is compressed by, encryption format information indicative of what format the music data is encrypted by and an additional information management table indicative of what data exists as the additional information. In addition, information relating to the audio file such as an artist name, a tune name, an album name, a composer name and a producer name is also included in the contents information.

The additional information includes text data such as a message of the artist and an episode in creating the album besides decode software (decode program) to expand the music data, equalizer software to adjust a tone of the music and image data of the artist.

There are a plurality of formats such as MP3 (MPEG-1 Audio Laye3), TwinVQ (Transform domain Weighed interleave vector quatization), AAC (MPEG2/Advanced Audio Coding), AC-3 (Dolby Digital), ePAC and etc. as a compression format of the music data. Thus, when the music data is compressed by the ePAC format, the compression format information included in the contents information indicates the "ePAC", and when the music data is compressed by the MP3 format, the compression format information included in the contents information indicates the "MP3".

Furthermore, there is a difference in useable decode software depending on types of a DSP (Digital Signal Processor) provided on a reproducing apparatus. There is a difference in the number of bits to perform a process (16-bit operation and 24-bit operation) as a difference of a type of the DSP. Accordingly, the useable decode software is different such that where the DSP is a processor to perform a 16-bit operation, only the decode software of a type A is activated, and where the DSP is a processor to perform a 24-bit operation, only the decode software of a type B is activated.

Thus, in a case that the decode software included in the additional information complies with the ePAC format and corresponding to the 16-bit operation DSP, "ePAC decode software-type A" is written to the additional information management table as decode software information. Furthermore, in a case two decode software complying with the ePAC format are included in the additional information so as to be available to both of the DSPs of the 16-bit operation and the 24-bit operation, the "ePAC decode software-type A" and "ePAC decode software-type B" are written to the additional information management table as the decode software information. As can be understood from the above-description, the decode software information is a concept including compression format information and type information.

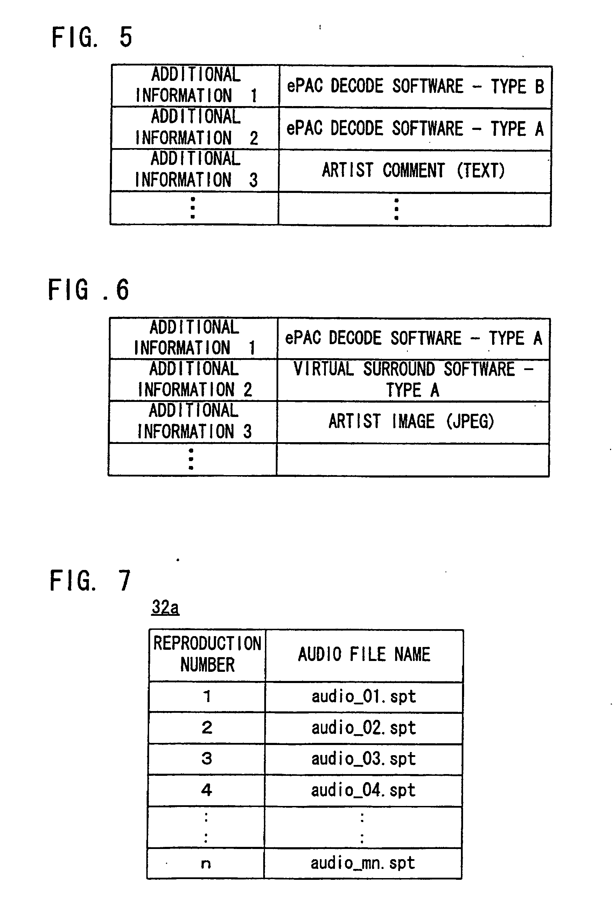

In this embodiment, it is preferable that decode software according to a common compression format and corresponding to both of the type A and the type B is housed in the audio file. In this case, the additional information management table is stored with information shown in Figure 5. According to Figure 5, the additional information 1 is the "ePAC decode software-type B", the additional information 2 is the "ePAC decode software-type A", and the additional information 3 is "a comment (TEXT) of the artist". There is a case that only one decode software is housed in the audio file, and alternatively, the DSP software to perform a special effect suitable for each of tunes is housed. At this time, the additional information management table is housed with information shown in Figure 6, for example. According to Figure 6, the additional information 1 is the "ePAC decode software-type A", the additional information 2 is "virtual sound software-type A", and the additional information 3 is an "artist image (JPEG)". It is noted that the virtual sound software is effective at a time of reproducing a tune recorded at a concert with a realistic sensation, for example.

There are following two methods for storing the decode software, the relating compression format information and the decode software information in the audio file. A first is a method for storing in the audio file the decode software, the compression format information and the decode software information on the side of the database server 200, and a second is a method for storing corresponding decode software, the compression format information and the decode software information in the audio file at a time of purchasing after the communication terminal 400 acquires in advance a plurality of decode software from the WEB site 300a or the database server 200.

It is noted that the audio file reproduced by the portable audio player 10 is downloaded from the database server 200 and then, recorded onto the memory card 18 or can alternatively be recorded onto the memory card 18 by reading a CD 500 (Figure 1). In this case, an audio file with a configuration shown in Figure 4 is formed by the communication terminal 400.

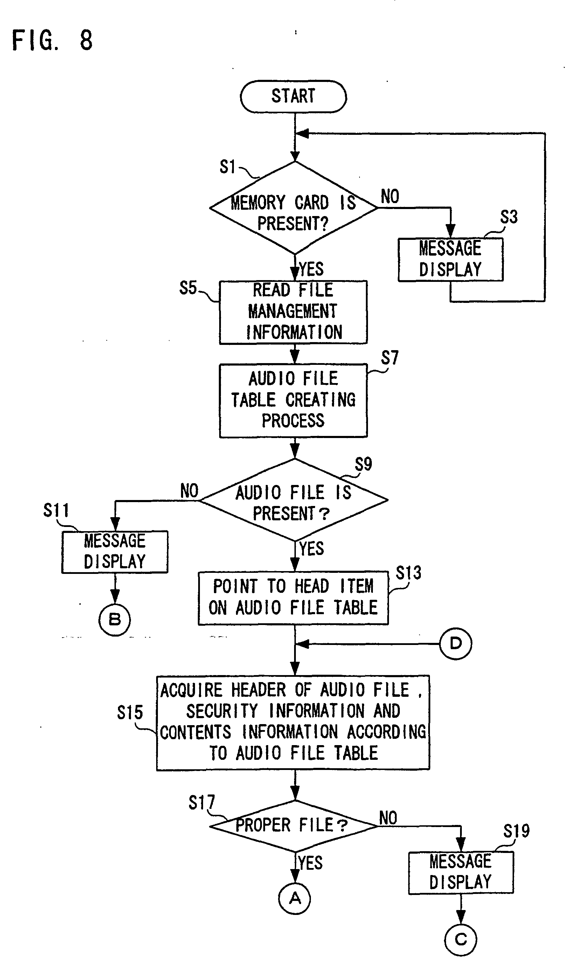

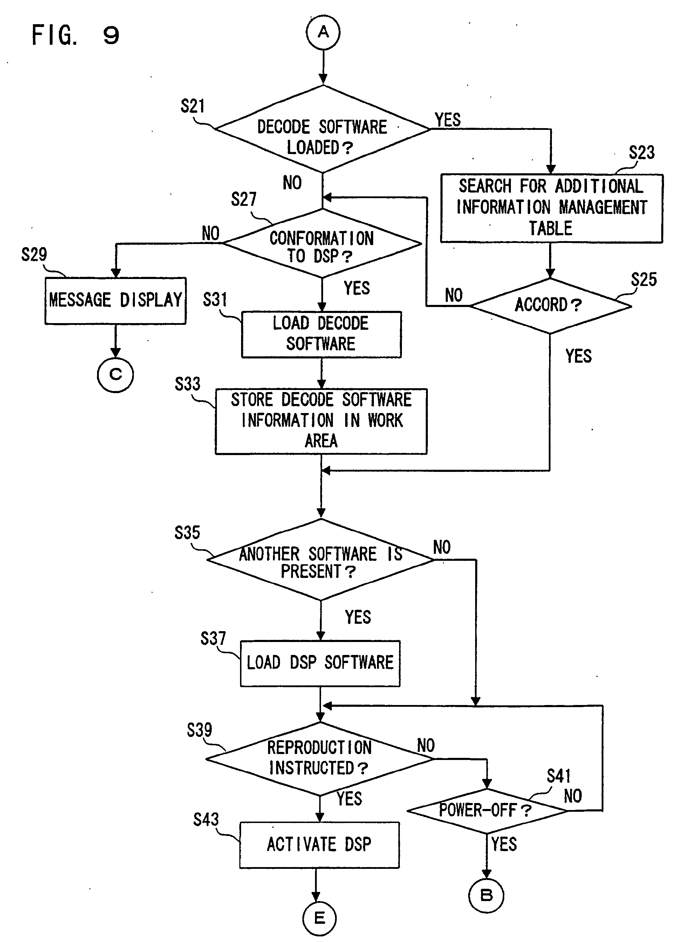

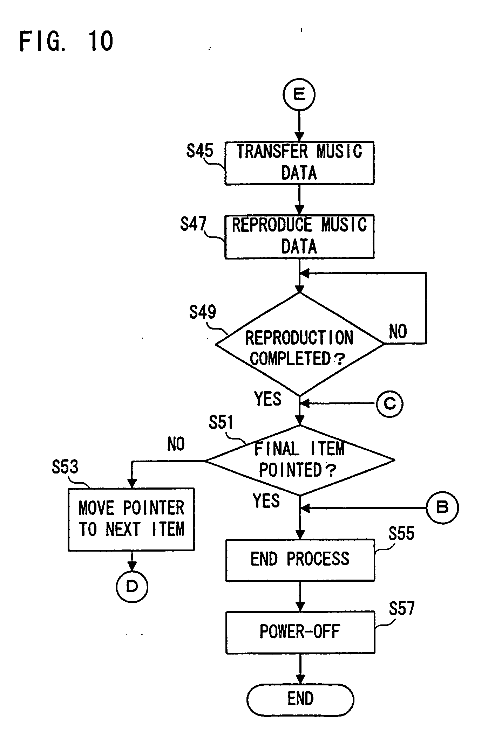

When the audio file thus recorded onto the memory card 18 is reproduced, the CPU 20 included in the portable audio player 10 processes flowcharts shown in Figure 8 to Figure 10. It is noted that the process of such flowcharts is started in response to application of power.

First, it is determined whether or not the memory card 18 is attached to the slot 16 in a step S1. If the memory card 18 is not attached, a message indicating that the memory card 18 is not attached is displayed on an LCD 36 in a step S3, and the process returns to the step S1. When the operator attaches the memory card 18 according to a message displayed on the LCD 36, the process proceeds from the step S1 to a step S5 so as to transfer file management information (see Figure 3) included in the memory card 18 to a memory (FEPROM) 32. The file management information is information to manage a data file recorded onto the memory card 18, and whereby, it is possible to understand what kind of data is stored in each of data files.

In a step S7, a file name of the audio file recorded onto the memory card 18 is detected on the basis of the file management information so as to create an audio file table 32a shown in Figure 7. Specifically, the data file name with an expansion of "spt" is detected from the file management information and set in the audio file table 32a regarding this as an audio file name. The audio file table 32a has a plurality of storage areas each of which is called an item, and each item is assigned with the identification number. The audio file name detected from the file management information is set from an item in ascending order of identification number.

After completion of a processing in the step S7, the process proceeds to a step S9 so as to determine whether or not at least one audio file name exists in the audio file table 32a. If "NO" herein, it is determined no audio file exists in the memory card 18, and a message of so is displayed on the LCD 36 for a predetermined time period in a step S11. After a lapse of the predetermined time period, an ending process and a power-off process are executed in a step S55 and in a step S57, respectively, and then, the process is ended.

On the other hand, if "YES" is determined in the step S9, a pointer is set to a head item on the audio file table 32a in a step S13. In a following step S15, the memory card 18 is accessed so as to acquire a header, security information and contents information from the audio file having a file name of the currently pointed item. At this time, the recording position of the audio file as an acquiring source is specified on the basis of the currently pointed file name and the file management information within the memory card 18.

In a step S17, it is determined whether or not the audio file is a proper file (that is, whether or not the audio file is not an unauthorized copied file) on the basis of the security information acquired in the step 15. If the audio file is not the proper file, a message of so is displayed on the LCD 36 for a predetermined time period in a step S19. Succeedingly, it is determined whether or not the pointer on the audio file table 32a points to a final item in a step S51, and if "NO", it is determined an audio file which has not reproduced is present and then, the process is returned to the step S15 after a moving process of the pointer in a step S53. The pointer points to a next item, and the above-described process is performed on the next audio file in the step S15. If "YES" is determined in the step S51, it is regarded an audio file which has not reproduced is not present, the ending process and the power-off process are executed in the steps S55 and S57, respectively, and then, the process is ended.

If "YES" is determined in the step S17 shown in Figure 8, it is determined whether or not the decode software has already loaded into a RAM 22a of a DSP 22 in a step S21. Immediately after an application of power, the decode software is not loaded into the RAM 22a. At this time, the process proceeds from the step S21 to a step S27 so as to determine whether or not the decode software included in the additional information is a type conforming to the DSP 22 by referring to the decode software information on the additional information management table. Herein, if the decode software is not conformed to the DSP 22, a message of so is displayed on the LCD 36 for a predetermined time period and then, the process proceeds to the step S51.

On the other hand, if the decode software is conformed to the DSP 22, "YES" is determined in the step S27, and the decode software is loaded from the memory card 18 to the RAM 22a of the DSP 22 in a step S31, and then, the decode software information of the decode software is stored in a work area 20a of the CPU 20 in a step S33. The decode software information stored in the work area 20a is especially defined as "soft ware identifying information". The software identifying information is utilized for identifying the decode software loaded into the RAM 22a.

When there is the loaded decode software in the RAM 22a, the process proceeds from the step S21 to a step S23 so as to search for the additional information management table rendering the software identifying information stored in the work area 20a as a key. Furthermore, it is determined whether or not the decode software information according with the software identifying information is present in the additional information management table in a step S25. If "YES" is determined herein, it is regarded the decode software corresponding to the audio file to be reproduced is present in the RAM 22a and there is no need to load the decode software again, and then, the process directly proceeds to a step S35. Thus, it is possible to shorten a time required to start a decoding process.

On the other hand, if "NO" is determined in the step S25, it is regarded that it is impossible to decode the audio file with the loaded decode software, and the process shifts to the step S27. In a case "YES" is determined in the step S27 and the decode software is loaded anew in the step S31, the decode software loaded in the RAM 22a is overwritten by the decode software loaded anew.

It is determined whether or not the DSP software except for the decode software such as the virtual sound software is included in the audio file with referring to the additional information management table in the step S35. If "NO" is determined herein, the process directly proceeds to a step S39 while if "YES" is determined, a loading process of the DSP software is executed in a step S37, and then, the process proceeds to the step S39. Thus, the preparation for reproducing the music data is completed, and a process according to a control of an operation panel 34 is performed after the step S39.

When the operator performs a reproducing operation, "YES" is determined in the step S39, and the DSP 22 is activated in a step S43. The music data is read from the audio file having a file name pointed by the pointer on the audio file table 32a in a step S45, and the read music data is transferred to the DSP 22. After completion of the process in the step S45, reproduction of the music data is instructed to the DSP 22 in a following step S47.

An encryption process and a compression process are performed on the music data. Thus, the DSP 22 receiving the reproducing instruction decrypts the music data on the basis of the encryption key information included in the security information and expands the decrypted compressed music data with the decode software stored in the RAM 22a. When the DSP software such as the virtual sound software exists in the RAM 22a, a process utilizing the DSP software and etc. is performed on the expanded music data. The music data thus processed is converted to a sound signal (analog signal) by a D/A converter 24, and the converted sound signal is output to a headphone 30 through an amplifier 26 and an output terminal 28.

It is determined whether or not one tune of reproduction is completed in a step S49. If "YES" is determined herein, the process proceeds to the step S51 so as to determine whether or not the pointer on the audio file table 32a points to the final item, that is, the reproduced music data is music data of the last audio file. When the pointer points to an item except the final item, the pointer is moved to a next item in a step S53, and then, the process returns to the step S15. On the other hand, when the pointer points to the final item, the ending process and the power-off process are respectively executed in the steps S55 and S57 and then, the process is ended. It is noted that when the operator performs the power-off operation, "YES" is determined in a step S41, and after the processes in the steps S55 and S57, the process is ended.

As can be understood from the above-description, the memory card 18 attached to the slot 16 is stored with a plurality of decoding programs respectively corresponding to a plurality of compression formats. The CPU 20 determines whether or not the decoding program corresponding to the compression format of the music data to be reproduced exists in the RAM 22a and transfers the decoding program from the memory card 18 to the RAM 22a in response to the determination result. That is, when the decoding program corresponding to the compression format of the music data to be reproduced exists in the RAM 22a, the same decoding program is never transferred. The music data is decoded by the DSP 22 according to the decoding program stored in the RAM 22a.

Accordingly, when a plurality of the music data complying with the same compression format are successively decoded, the decoding program is not repeatedly transferred, and therefore, it is possible to shorten a time to start the decoding process of the music data.

It is noted that although accord/discord between the respective audio files is determined as to the only decode software in this embodiment, the accord/discord between the respective audio files may be determined as to another DSP software alternative to or in addition to this.

Furthermore, the loaded decode software is stored in the RAM in this embodiment, and therefore, the decoded software is deleted at a time of power-off; however, if the loaded decode software and the software identifying information are stored in a nonvolatile memory such as a flash memory and etc., the loaded decode software can make effective after the power-off.

In addition, the RAM of the DSP is stored with the only one decode software, however; it is preferable that a plurality of decode software are stored in the RAM, and only when music data corresponding to no decode software is reproduced, another decode software is loaded into the RAM.

Furthermore, if music data according to another compression format is reproduced after the music data complying with the same compression format is successively reproduced during several tunes, non-music time between tunes varies by a time required to load the decode software. This problem can be solved by shortening the non-music time between the tunes by a time required for loading the decode software when reproducing music data according to the compression format different from that in previous time.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A decoding apparatus for decoding an encoded signal encoded according to any one of a plurality of encoding formats, comprising:
an attachment means for attaching an external memory storing a plurality of decoding programs respectively corresponding to said plurality of encoding formats;
an internal memory for storing at least one of said plurality of decoding programs; a determination means for determining whether or not a specific decoding program corresponding to the encoding format of said encoded signal exists in said internal memory;
a transfer means for transferring said specific decoding program from said external memory to said internal memory according to a determination result of said determination means; and
a decoding means for decoding said encoded signal according to the decoding program stored in said internal memory.

2. A decoding apparatus according to claim 1, wherein
said external memory stores a plurality of encoded signals complying with the same encoding format.

3. A decoding apparatus according to claim 2, wherein
a decoding program and an encoded signal corresponding with each other are stored in the same data file.

4. A decoding apparatus according to any one of claims 1 to 3, wherein
said encoded signal is a compressed music signal.
